# EUROPEAN PATENT APPLICATION

(11) **EP 4 852 256 A1**
(43) Date of publication of application: **09.12.2026**
(21) Application number: 25192858.6
(22) Date of filing: 30.07.2025
(51) Int. Cl.: H02H 9/04, H03F 3/45

(54) **DRIVE CIRCUIT AND ELECTRONIC DEVICE**

(30) Priority: 06.06.2025 CN 202510756412
(71) Applicant: Shenzhen Sunricher Technology Co., Ltd., Shenzhen, Guangdong 518000 (CN)
(72) Inventor: GONG, Fei, Shenzhen, Guangdong, 518000 (CN)
(74) Representative: Biallo, Dario

(57) **Abstract**

This application is applicable for the field of electronic device technology, and provides a drive circuit (10) and an electronic device. The drive circuit (10) includes a control module (101), an integral filter module (102), an operational amplifier module (103) and a current regulation module (104). The integral filter module (102) is in electrical connection with the control module (101) and the operational amplifier module (103), respectively. The current regulation module (104) is in electrical connection with the operational amplifier module (103). The current regulation module (104) is configured to be electrically connected to a load (20). The control module (101) is configured to output a first voltage signal to the integral filter module (102). The integral filter module (102) is configured to output a second voltage signal to the operational amplifier module (103) according to the first voltage signal. The operational amplifier module (103) is configured to output a first operational amplifier signal to the current regulation module (104) according to the second voltage signal and a node voltage. The node voltage is a voltage at a common node of the current regulation module (104) and the load (20). The current regulation module (104) is configured to increase a current delivered to the load (20) in response to the first operational amplifier signal. The drive circuit (10) provided in the embodiment of the present application exhibits strong load-driving capacity and high output accuracy.

## Description

### TECHNICAL FIELD

The present application relates to the field of electronic device technology, more particularly to a drive circuit and an electronic device.

### BACKGROUND

In the development process of modern industrial automation and intelligence, analog signal control technology is widely applied across numerous fields. In typical application scenarios such as 0-10V signal driver and industrial control system, a traditional drive circuit is usually composed of an MCU, an integral filter circuit and an operational amplifier circuit. To ensure the high precision of the output signal, a designer usually selects an operational amplifier with a small offset voltage. However, due to their inherent characteristic limitations, such operational amplifiers often exhibit weak load-driving capacity, failing to meet the requirements for driving larger loads.

### SUMMARY

Embodiments of the present application provide a drive circuit and an electronic device, which can address the issue of existing drive circuits having insufficient load-driving capacity to meet the demands of driving larger loads.

In accordance with a first aspect, an embodiment of the present application provides a drive circuit, which includes a control module, an integral filter module, an operational amplifier module and a current regulation module. The integral filter module is in electrical connection with the control module and the operational amplifier module respectively, the current regulation module is in electrical connection with the operational amplifier module, and the current regulation module is configured to be electrically connected to a load.

The control module is configured to output a first voltage signal to the integral filter module. The integral filter module is configured to output a second voltage signal to the operational amplifier module according to the first voltage signal. The operational amplifier module is configured to output a first operational amplifier signal to the current regulation module according to the second voltage signal and a node voltage. The node voltage is a voltage at a common node of the current regulation module and the load. The current regulation module is configured to increase a current delivered to the load in response to the first operational amplifier signal.

In a possible implementation of the first aspect, the integral filter module includes a first resistor and a first capacitor. A first end of the first resistor is in electrical connection with the control module. A second end of the first resistor is in electrical connection with the first end of the first capacitor and the operational amplifier module respectively, and a second end of the first capacitor is grounded.

In a possible implementation of the first aspect, the operational amplifier module includes a second resistor, a third resistor and a first operational amplifier. A first input end of the first operational amplifier is in electrical connection with the integral filter module. A second input end of the first operational amplifier is in electrical connection with a first end of the second resistor and a first end of the third resistor respectively. An output end of the first operational amplifier is in electrical connection with the current regulation module. A second end of the second resistor is grounded, and a second end of the third resistor is configured to be electrically connected to the load.

In a possible implementation of the first aspect, the current regulation module includes a fourth resistor, a fifth resistor, a sixth resistor, a first transistor and a second transistor. A first end of the fourth resistor is configured to be electrically connected to the first power supply. A second end of the fourth resistor is in electrical connection with a collector of the first transistor. A first end of the fifth resistor is in electrical connection with a first end of the sixth resistor and the operational amplifier module respectively. A second end of the fifth resistor is in electrical connection with a base of the first transistor. A base of the second transistor is in electrical connection with a second end of the sixth resistor. A collector of the second transistor is grounded, and an emitter of the second transistor is in electrical connection with an emitter of the first transistor and the load respectively.

In a possible implementation of the first aspect, the control module includes a control chip, and the control chip is in electrical connection with the integral filter module.

In a possible implementation of the first aspect, the drive circuit also includes a feedback module. The feedback module is in electrical connection with the current regulation module and the control module respectively. The feedback module is configured to output a feedback voltage signal to the control module according to the node voltage. The control module is also configured to regulate the first voltage signal according to the feedback voltage signal.

In a possible implementation of the first aspect, the feedback module includes a seventh resistor and an eighth resistor. A first end of the seventh resistor is in electrical connection with a first end of the eighth resistor and the control module respectively. A second end of the seventh resistor is grounded, and a second end of the eighth resistor is configured to be electrically connected to the load.

In a possible implementation of the first aspect, the drive circuit also includes a protection module. The protection module is in electrical connection with the current regulation module and the load respectively. The protection module is configured to switch to a protection state under a preset condition.

In a possible implementation of the first aspect, the protection module includes a first transient voltage suppressor (TVS) diode and a first thermistor. A first end of the first TVS diode is in electrical connection with a first end of the first thermistor and the current regulation module respectively. A second end of the first TVS diode is grounded, and a second end of the first thermistor is configured to be electrically connected to the load.

In a second aspect, an electronic device is provided. The electronic device includes the drive circuit in any one of implementations of the first aspect.

Compared with the existing technologies, the embodiments of the present application have the following beneficial effects:
The drive circuit provided by the embodiment of the present application includes a control module, an integral filter module, an operational amplifier module and a current regulation module. The control module is configured to output a first voltage signal. The integral filter module is configured, after receiving the first voltage signal, to perform integral and filtering processing on the first voltage signal, to obtain a second voltage signal and transmit the second voltage signal to the operational amplifier module. The operational amplifier module can receive the second voltage signal and a node voltage, and output a first operational amplifier signal to the current regulation module according to the second voltage signal and the node voltage. The current regulation module is configured, in response to the first operational amplifier signal, to increase an output current of the current regulation module, that is, to increase a current delivered to the load. Thus, as demonstrated, the drive circuit provided in the embodiments of the present application achieves current regulation to the load by incorporating a current regulation module downstream of the operational amplifier (op-amp) module. When the load is large, the current regulation module can play a role of current amplification, significantly increasing the current delivered to the load and effectively enhancing the load-driving capacity of the drive circuit, and thus can meet the requirements of driving larger loads.

It can be understood that the beneficial effects of the second aspect can be referred to the related description in the first aspect, which thus will not be reiterated here.

### BRIEF DESCRIPTION OF THE DRAWINGS

To illustrate technical schemes in the embodiments of the present application more clearly, the following will briefly introduce the drawings required in the description of the embodiments or the existing technologies. Obviously, the drawings in the following description merely some embodiments of the present application, and for persons skilled in this field, other drawings may also be obtained based on these drawings without exerting creative efforts.
FIG. 1 is a schematic circuit diagram of a conventional drive circuit;
FIG. 2 is a schematic functional block diagram of a drive circuit provided by an embodiment of the present application;
FIG. 3 is a schematic circuit diagram of the drive circuit provided by an embodiment of the present application;
FIG. 4 is a schematic functional block diagram of a drive circuit provided by another embodiment of the present application; and
FIG. 5 is a schematic circuit diagram of the drive circuit provided by another embodiment of the present application.

Reference numerals in the drawings are mainly listed as follow: 10, drive circuit; 101, control module; 102, integral filter module; 103, operational amplifier module; 104, current regulation module; 105, feedback module; 106, protection module; and 20, load.

### DETAILED DESCRIPTION OF THE EMBODIMENTS

In the following description, for purposes of explanation and not limitation, specific details are set forth, such as particular architectures, techniques, etc. in order to provide a thorough understanding of the present embodiments. However, it will be apparent to those skilled in the art that the present application can be practiced in other embodiments that depart from these specific details. In other instances, detailed descriptions of well-known systems, devices, circuits, and methods are omitted so as not to obscure the description of the present application with unnecessary detail.

It should be understood that when used in the specification and the appended claims of the present application, the term "comprising/including" indicates the presence of the described features, elements, steps, operations, components and/or assemblies, but does not preclude the presence or addition of one or more other features, elements, steps, operations, components, assemblies and/or their combinations.

It should also be understood that the term "and/or" used in the specification and appended claims of the present application refers to any combination of one or more of the associated listed items as well as all possible combinations, and includes these combinations.

As used in the specification and the appended claims of the present application, the term "if' can be construed to mean "when" or "upon" or "in response to determining" or "in response to detecting," depending on the context. Similarly, the phrase "if it is determined" or "if [a described condition or event] is detected" can be construed to mean "upon determining" or "in response to determining" or "upon detecting [the described condition or event]" or "in response to detecting [the described condition or event]," depending on the context.

In addition, in the description of the specification and the appended claims of the present application, the terms "first", "second", "third", etc. are used only to distinguish the description and cannot be understood as indicating or implying relative importance.

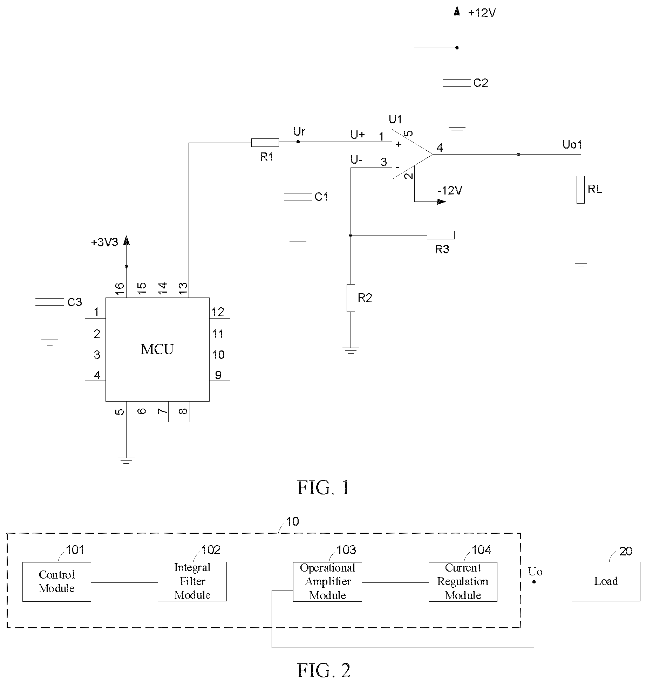

In the description of the present application, references to "one embodiment" or "some embodiments" or the like mean that a specific feature, structure, or characteristic described in connection with the embodiment is included in one or more embodiments of the present application. Thus, the appearances of the phrases "in one embodiment" or "in some embodiments" or "in other embodiments" or "in some other embodiments" or the like in various places throughout the present application do not necessarily all refer to the same embodiment, but rather mean "one or more but not all embodiments," unless otherwise specifically emphasized in alternative manners. The terms "comprising", "including" and "having" and their variations all imply "including but not limited to", unless otherwise specifically emphasized in alternative manners. In the development process of modern industrial automation and intelligence, analog signal control technology is widely used in many fields. In typical application scenarios such as 0-10V signal driver and industrial control system, as shown in FIG. 1, a traditional drive circuit is usually composed of an MCU, an integral filter circuit (R1 and C1) and an operational amplifier circuit (U1, R2, R3 and C2). In order to ensure the high precision of the output signal, the designer usually selects an operational amplifier U1 with a small offset voltage. However, due to the limitation of its own characteristics, such an operational amplifier often exhibits weak load-driving capacity, and cannot meet the demand of driving a large load.

In view of the above issues, a drive circuit is provided in an embodiment of the present application. The drive circuit includes a control module, an integral filter module, an operational amplifier module and a current regulation module. Here, the control module is configured to output a first voltage signal. The integral filter module is configured to, after receiving the first voltage signal, perform integral and filtering processing on the first voltage signal to obtain a second voltage signal, and transmit the second voltage signal to the operational amplifier module. The operational amplifier module can receive the second voltage signal and a node voltage, and output a first operational amplifier signal to the current regulation module according to the second voltage signal and the node voltage. The current regulation module is configured, in response to the first operational amplifier signal, to increase an output current of the current regulation module, that is, to increase a current delivered to the load. Therefore, the drive circuit provided in the embodiments of the present application achieves current regulation to the load by incorporating a current regulation module downstream of the operational amplifier (op-amp) module. When the load is large, the current regulation module can play a role of current amplification, significantly increasing the current delivered to the load, effectively enhancing the load-driving capacity of the drive circuit, and thus can meet the requirements for driving larger loads.

To illustrate the technical schemes of the present application, the following specific embodiments are used for illustration.

FIG. 2 shows a schematic block diagram of the drive circuit 10 according to an embodiment of the present application. Referring to FIG. 2, the drive circuit 10 includes a control module 101, an integral filter module 102, an operational amplifier module 103, and a current regulation module 104. The integral filter module 102 is in electrical connection with the control module 101 and the operational amplifier module 103, respectively. The current regulation module 104 is in electrical connection with the operational amplifier module 103, and is configured to be electrically connected to the load 20.

Particularly, the control module 101 is configured to output a first voltage signal. The integral filter module 102 is configured to, after receiving the first voltage signal, perform integral and filtering processing on the first voltage signal, to obtain a second voltage signal and transmit the second voltage signal to the operational amplifier module 103. The operational amplifier module 103 may receive the second voltage signal and a node voltage, and output a first operational amplifier signal to the current regulation module 104 according to the second voltage signal and the node voltage. The current regulation module 104 is configured, in response to the first operational amplifier signal, to increase an output current of the current regulation module 104, that is, to increase a current delivered to the load 20. As demonstrated, the drive circuit 10 provided in the embodiments of the present application achieves current regulation to the load 20 by incorporating a current regulation module 104 downstream of the operational amplifier module 103. When the load 20 is large, the current regulation module 104 can play a current-boosting role, and significantly increase the current delivered to the load 20, thereby effectively improving the load-driving capacity of the drive circuit 10, and meeting the requirement of driving a large load 20.

It should be noted that the first voltage signal may be a PWM (Pulse Width Modulation) signal, and the control module 101 may regulate a duty cycle of the PWM signal to achieve regulation and control of the downstream circuit. The integral filter module 102 may perform integral operation on discrete pulse sequences in the PWM signal, causing the voltage value of the signal to gradually accumulate and change over time, and also filter out high-frequency noise and ripple interference. After this series of processing, the PWM signal originally having the high-frequency jump characteristic can be converted into a smoother and more stable second voltage signal.

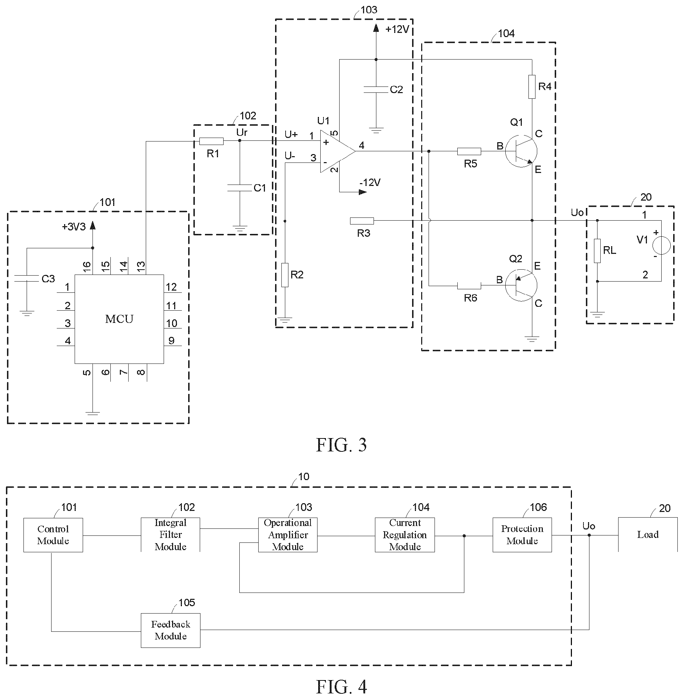

In an embodiment of the present application, as shown in FIG. 3, the control module 101 includes a control chip MCU. The control chip MCU is in electrical connection with the integral filter module 102.

Particularly, a pin 13 of the control chip MCU is in electrical connection with the integral filter module 102, and configured for outputting a first voltage signal (such as a PWM signal) to the integral filter module 102. The control chip MCU may precisely regulate parameters such as the frequency and duty cycle of the PWM signal to meet the requirements of different loads and application scenarios. In addition, the control chip MCU may also receive external commands or control signals and adjust its working mode or parameter settings based on these input signals. The control chip MCU may also monitor the key parameters in the circuit, such as voltage, current, etc., and take protective measures promptly when abnormal conditions (such as overload, short circuit, etc.) are detected, such as stopping the output signal or issuing an alarm signal, to prevent circuit components from being damaged due to faults and to enhance the safety and stability of the entire system.

It should be noted that a pin 16 of the control chip MCU is a power supply pin for receiving a power supply voltage (such as 3.3V), and a third capacitor C3 is also connected at the pin 16 of the control chip MCU for filtering the power supply voltage to prevent high-frequency signals from interfering with the control chip MCU. A pin 5 of the control chip MCU is a grounding pin for grounding.

In one embodiment of the present application, as shown in FIG. 3, the integral filter module 102 includes a first resistor R1 and a first capacitor C1, a first end of the first resistor R1 is in electrical connection with the control module 101, a second end of the first resistor R1 is in electrical connection with a first end of the first capacitor C1 and the operational amplifier module 103 respectively, and a second end of the first capacitor C1 is grounded.

Particularly, the first resistor R1 has a hindering effect on the current, which affects the charging and discharging process of the first capacitor C1. The first capacitor C1 has the characteristics of passing alternating current and blocking direct current, and in the integral filter module 102, the first capacitor C1 can filter out the high-frequency components and clutter interference in the PWM signal. The first resistor R1 and the first capacitor C1 constitute a first-order RC integral circuit, and in the RC integral circuit, the first capacitor C1 can perform integral processing on the input PWM signal. When the high level of the PWM signal arrives, the first capacitor C1 begins to charge; when the low level of the PWM signal arrives, the first capacitor C1 begins to discharge. Through the continuous charging and discharging process, the voltage across the first capacitor C1 will exhibit an integration effect on the input signal, thereby converting the discrete PWM signal into a continuously varying second voltage signal.

It should be noted that the embodiments provided in the present application only illustrate one circuit structure as the integral filter module 102, which does not mean that only this circuit structure can achieve the functionality of the integral filter module 102. Other circuit structures capable of achieving this function may also be substituted, and are not limited to this.

In one embodiment of the present application, as shown in FIG. 3, the operational amplifier module 103 includes a second resistor R2, a third resistor R3 and a first operational amplifier U1. A first input end of the first operational amplifier U1 is in electrical connection with the integral filter module 102, a second input end of the first operational amplifier U1 is in electrical connection with a first end of the second resistor R2 and a first end of the third resistor R3 respectively, an output end of the first operational amplifier U1 is in electrical connection with the current regulation module 104, a second end of the second resistor R2 is grounded, and a second end of the third resistor R3 is configured to be electrically connected to the load 20. Particularly, the second resistor R2 and the third resistor R3 constitute a negative feedback regulation circuit, and the node voltage may be divided through the second resistor R2 and the third resistor R3, the divided voltage is transmitted to the second input end of the first operational amplifier U1. The second resistor R2 and the third resistor R3 can stabilize the gain of the first operational amplifier U1, reduce signal distortion, and improve the stability and anti-interference ability of the circuit. The first input end of the first operational amplifier U1 is a non-inverting input terminal, the second input end of the first operational amplifier U1 is an inverting input terminal, the first operational amplifier U1 has the characteristics of high gain and high precision, and is capable of amplifying a weak input signal to a sufficient level of amplitude, that is, the first operational amplifier U1 can amplify the second voltage signal received at the non-inverting input terminal. Meanwhile, the two input ends of the first operational amplifier U1 receive the second voltage signal and the divided voltage respectively, and compare and process the two signals, and regulate the amplitude and polarity of a first operational amplifier signal according to a difference between the two signals. In this way, precise control over the first operational amplifier signal is achieved, enabling it to regulate accordingly based on the requirements of load 20 and changes in the input signal, thus ensuring the stability and accuracy of the entire drive circuit 10.

It should be noted that a ratio of the third resistor R3 to the second resistor R2 determines a feedback coefficient, and thus affects the closed-loop gain of the first operational amplifier U1. By reasonably selecting resistance values of the third resistor R3 and the second resistor R2, the gain of the operational amplifier module 103 can be accurately set to meet different signal amplification requirements.

It should be noted that the first operational amplifier U1 is powered by dual power supplies, that is, the pin 5 of the first operational amplifier U1 is connected to a first power supply for receiving a positive supply voltage (such as +12V), and the pin 2 of the first operational amplifier U1 is configured for receiving a negative supply voltage (such as -12V), such design can ensure that the voltage output from the current regulation module 104 can be as low as zero volt, and can meet more extensive signal processing requirements. It guarantees that the current regulation module 104 can more flexibly control the current delivered to the load 20, to meet the operating requirements of different types of loads 20. In addition, a second capacitor C2 is also connected at the pin 5 of the first operational amplifier U1 to filter the positive power supply voltage and prevent high-frequency signals from interfering with the first operational amplifier U1.

It should be noted that the embodiments provided in the present application only illustrate one circuit structure as the operational amplifier module 103, which does not mean that only this circuit structure can achieve the function of the operational amplifier module 103. Other circuit structures capable of achieving this function may also be substituted, and are not limited to this.

In one embodiment of the present application, as shown in FIG. 3, the current regulation module 104 includes a fourth resistor R4, a fifth resistor R5, a sixth resistor R6, a first transistor Q1 and a second transistor Q2. A first end of the fourth resistor R4 is configured to be electrically connected to the first power supply. A second end of the fourth resistor R4 is in electrical connection with a collector of the first transistor Q1. A first end of the fifth resistor R5 is in electrical connection with a first end of the sixth resistor R6 and the operational amplifier module 103 respectively. A second end of the fifth resistor R5 is in electrical connection with a base of the first transistor Q1. A base of the second transistor Q2 is in electrical connection with a second end of the sixth resistor R6. A collector of the second transistor Q2 is grounded. An emitter of the second transistor Q2 is in electrical connection with an emitter of the first transistor Q1 and the load 20 respectively.

Particularly, the fourth resistor R4 is configured for current limiting and protection, and is connected between the first power supply and the collector of the first transistor Q1. When the first power supply provides current to the first transistor Q1, the fourth resistor R4 can limit the current, thereby avoiding damage to the first transistor Q1 caused by excessive current. Meanwhile, the fourth resistor R4 can play a certain buffering role to protect the first power supply and other circuit elements in the case of abnormal conditions (such as short circuit) of the circuit. The fifth resistor R5 and the sixth resistor R6 are respectively arranged at the base of the first transistor Q1 and the base of the second transistor Q2, and can limit the current flowing into the base of the first transistor Q1 and the base of the second transistor Q2, inhibit high-frequency self-oscillation, and control the conduction degree of the first transistor Q1 and the second transistor Q2. Meanwhile, the fifth resistor R5 plays a certain isolation role between the operational amplifier module 103 and the first transistor Q1, reducing the mutual influence therebetween. The fifth resistor R5 may buffer the change of the output signal of the operational amplifier module 103, avoiding impact of signal mutation on the first transistor Q1 and improving the stability of the circuit. The sixth resistor R6 plays a certain isolation role between the operational amplifier module 103 and the second transistor Q2, reducing the mutual influence therebetween. The sixth resistor R6 may buffer the change of the output signal of the operational amplifier module 103, avoiding impact of signal mutation on the second transistor Q2 and improving the stability of the circuit. The first transistor Q1 and the second transistor Q2, serving as main amplifying elements of the current regulation module 104, output large current at their emitters by utilizing the current amplification characteristics thereof, thereby a large current is provided to the load 20.

It should be noted that the first transistor Q1 is of NPN type, and the second transistor Q2 is of PNP type, thereby a push-pull circuit is formed.

In case that the load 20 is a passive load, the first operational amplifier signal output from the operational amplifier module 103 gradually increases, and for the NPN type first transistor Q1, a base voltage rises and an emitter junction is positively biased. The first transistor Q1 starts to be switched on when a voltage difference between the base voltage and the emitter voltage reaches a certain degree. At this point, a conductive path is formed between the collector and the emitter of the first transistor Q1, and the current flows from the first power supply to the load 20 through the fourth resistor R4, the collector and the emitter of the first transistor Q1, thereby a forward driving current is provided to the load 20.

In case that the load 20 is an active load, an emitter junction of the second transistor Q2 is positively biased when a voltage of the first operational amplifier signal output from the operational amplifier module 103 is lower than a voltage across the load 20. The second transistor Q2 starts to be switched on when the voltage difference between the base voltage and the emitter voltage reaches a certain degree. At this point, a conductive path is formed between the emitter of the second transistor Q2 and the ground, and the voltage across the active load is accurately controlled within a range of 0-10V, achieving a voltage variation of 0-10V.

It should be noted that the embodiments provided in the present application only illustrate one circuit structure as the current regulation module 104, which does not mean that only this circuit structure can achieve the function of the current regulation module 104. Other circuit structures capable of achieving this function may also be substituted, and are not limited to this.

It should be noted that the amplification characteristics of the non-inverting amplifier shown in FIG. 1 satisfy: ${u}^{o 1} = \left(1+\frac{{R}_{3}}{{R}_{2}}\right) ∗ {u}^{r}$

In the above formula, *u^{o1}* is an output voltage of the non-inverting amplifier, and *u^{r}* is a forward input voltage of the non-inverting amplifier.

The drive circuit 10 shown in FIG. 3 still satisfies the above formula, and the specific analysis is provided as follows:
A switching gain of the first operational amplifier U1 is set as a, and a closed-loop gain of the first operational amplifier U1 is set as: $A = \frac{{R}_{3} + {R}_{2}}{{R}_{2}} .$

Using the voltage division theorem, a first formula is obtained: ${u}^{-} = {u}^{o 2} ∗ \frac{{R}_{2}}{{R}_{2} + {R}_{3}} = \frac{{u}^{o 2}}{A}$

The first formula is rearranged to obtain a second formula: ${u}^{o 2} = \left({u}^{r}-{u}^{-}\right) ∗ a - VR 5 - VBE$

In the second formula, *u*⁻ is a voltage at the second input end of the first operational amplifier U1, *u^{r}* is a voltage at the first input end of the first operational amplifier U1, *u^{o2}* is an output voltage of the drive circuit 10, i.e., the node voltage, *VR5* is a voltage drop across the fifth resistor R5, and *VBE* is a PN junction voltage drop of the first transistor Q1.

Dividing both sides of the second formula by a, a third formula is obtained: $\frac{{u}^{o 2}}{a} = \left({u}^{r}-{u}^{-}\right) - \frac{VR 5}{a} - \frac{VBE}{a}$

Since an open-loop gain of the first operational amplifier U1 is large, such as AoL = 140V/mV of lm358, the following is obtained: $\frac{{u}^{o 2}}{a} \to 0$

Thus, the third formula may be expressed as a fourth formula: $0 = \left({u}^{r}-{u}^{-}\right) - \frac{VR 5}{a} - \frac{VBE}{a}$

Substituting the first formula into the fourth formula, a fifth formula is obtained: $0 = \left({u}^{r}-\frac{{u}^{o 2}}{A}\right) - \frac{VR 5}{a} - \frac{VBE}{a}$

The fifth formula is arranged to obtain a sixth formula: $\frac{{u}^{o 2}}{A} = {u}^{r} - \frac{VR 5}{a} - \frac{VBE}{a}$

Multiplying both sides of the sixth formula by A, a seventh formula is obtained: ${u}^{o 2} = A ∗ {u}^{r} - \frac{A}{a} ∗ VR 5 - \frac{A}{a} ∗ VBE$

Since a >> A, A/a → 0.

Therefore, u^{o2} *= A _{*} u^{r}.*

In summary, u^{o2} demonstrated in the present application is also applicable to a formula: ${u}^{o 2} = \left(1+\frac{{R}_{3}}{{R}_{2}}\right) ∗ {u}^{r}$

Meanwhile, the present application also retains the current amplification characteristics Ic = β * Ib of the first and second transistors Q1 and Q2, which can increase the current delivered to the load 20 and enhance the output load-driving capacity.

The conventional drive circuit 10 composed of an MCU, an integral filter circuit and an operational amplifier circuit as shown in FIG. 1 often suffers from limited accuracy issues, particularly when the load 20 changes, causing the output voltage to potentially deviate from the desired value.

Based on the above problem, the drive circuit 10 according to an embodiment of the present application, as shown in FIG. 4, also includes a feedback module 105. The feedback module 105 is in electrical connection with the current regulation module 104 and the control module 101 respectively, the feedback module 105 is configured to output a feedback voltage signal to the control module 101 according to the node voltage, and the control module 101 is also configured to regulate the first voltage signal according to the feedback voltage signal.

Particularly, a closed-loop control system is constituted by the node voltage (output voltage), the feedback module 105 and the control chip MCU. The feedback module 105 may monitor the node voltage in real time, divide the node voltage to obtain the feedback voltage signal, and transmit the feedback voltage signal to the control chip MCU. The control chip MCU, after receiving the feedback voltage signal, may recognize a magnitude of the node voltage, and regulate the duty cycle of the first voltage signal transmitted to the integral filter module 102 according to the node voltage, so as to compensate for the output voltage deviation caused by the variation of the load 20 and realize a fast dynamic response. Thus, it is ensured that the control chip MCU can accurately control the signal output according to the feedback voltage signal, and the precision of the signal output is improved.

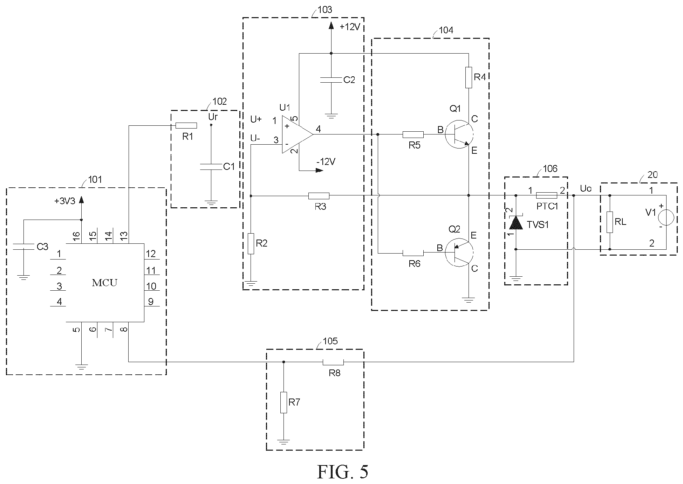

In an embodiment of the present application, as shown in FIG. 5, the feedback module 105 includes a seventh resistor R7 and an eighth resistor R8, a first end of the seventh resistor R7 is in electrical connection with a first end of the eighth resistor R8 and the control module 101 respectively, a second end of the seventh resistor R7 is grounded, and a second end of the eighth resistor R8 is configured to be electrically connected to the load 20.

Particularly, the seventh resistor R7 and the eighth resistor R8 are configured to divide the node voltage (output voltage) and transmit the feedback voltage signal obtained after voltage division to the control chip MCU, enabling the control chip MCU to regulate the duty cycle of the first voltage signal through the feedback voltage signal, and ensuring the stability and accuracy of the output voltage.

It should be noted that the resistance values of the seventh resistor R7 and the eighth resistor R8 are not limited herein, for example, the resistance values of the seventh resistor R7 and the eighth resistor R8 may both be fixed resistance values or variable resistance values. In addition, apart from employing one seventh resistor R7 and one eighth resistor R8, the designers may also utilize other quantities of seventh resistors R7 and eighth resistors R8. For instance, two or more seventh resistors R7 may be used that are connected in series or parallel, and similarly two or more eighth resistors R8 may be used that are connected in series or parallel. FIG. 5 of the present application only shows that the feedback module 105 includes a circuit structure in which one seventh resistor R7 and one eighth resistor R8 with fixed resistance values are connected in series, and different numbers, different types, or different connection relationships of resistors may be used to replace the seventh resistor R7 and the eighth resistor R8, and the basic working principles are similar, thus, no more details are given herein.

It should be noted that the present application combines the current amplification capacity of the push-pull circuit with the dynamic regulation of closed-loop feedback, compensates a voltage drop (such as the VBE temperature drift of the push-pull transistor) caused by the variation of the load 20 in real time through the PID algorithm, eliminates the steady-state error, and can achieve an accuracy of ±0.5% within a full range of the load 20.

It should be noted that the embodiments provided in the present application only illustrate one circuit structure as the feedback module 105, which does not mean that only this circuit structure can achieve the function of the feedback module 105. Other circuit structures capable of achieving this function may also be substituted, and are not limited to this.

Exemplarily, the feedback voltage signal Uri transmitted by the feedback module 105 to the control chip MCU satisfies: $Uri = Uo ∗ f$

Here, f is a feedback coefficient, and the feedback module is composed of the seventh resistor R7 and the eighth resistor R8. If it is assumed that f = 0.2, then the feedback voltage signal Uri after voltage division by the seventh resistor R7 and the eighth resistor R8 is 20% of the output voltage Uo. The control chip MCU is configured to measure the feedback voltage signal Uri by ADC and calculate the output voltage Uo which is used to regulate the duty cycle of the first voltage signal.

Exemplarily, if the variation of the load 20 causes the output voltage Uo to become 9.5V, then it is indicated that the output voltage Uo deviates from 0.5V, and in this case, the feedback voltage signal Uri = 9.5V * 0.2 = 1.9V. The control chip MCU, after detecting a feedback voltage of 1.9V, may recognize that the output voltage Uo is low, and then increase the duty cycle of the first voltage signal to make Ur rise, thereby the output voltage Uo is increased. Conversely, if the output voltage Uo is higher than a target voltage of 10V, then the control chip MCU may reduce the duty cycle of the first voltage signal to ensure that the output voltage Uo is maintained at the target voltage 10V. Therefore, the present application achieves the closed-loop control through a combination of the control module 101 and the feedback module 105, so as to regulate the output voltage Uo and improve the accuracy of the output signal.

It should be noted that the relationship between the duty cycle of the PWM signal and the output voltage Uo may be described by way of example.

Exemplarily, if it is assumed that the maximum voltage of the PWM signal output from the control chip MCU is 3.3V, then the output voltage Uo obtained after the processing of the operational amplifier module 103 and the current regulation module 104 is: $Uo = \left(1+R3/R2\right) ∗ Ur = 3.75 ∗ Ur$

Here, Ur is the voltage at the first input end of the first operational amplifier U1, and 3.75 is a set amplification factor of the non-inverting amplifier.

If it is assumed that the duty cycle of the MCU is 100% (that is, Ur = 3.3V), then: $Uo = 3.3 V ∗ 3.75 = 12.375 V$

However, the target output voltage is 10V, so the control chip MCU is required to reduce the duty cycle of the PWM signal.

Exemplarily, the calculation of the duty cycle when the target output voltage is 10V may be described by way of example.

When the target output voltage is 10V, the required PWM duty cycle is calculated as follows: $Ur = Uo / 3.75 = 10 V / 3.75 = 2.6667 V$

The PWM signal output from the control chip MCU ranges from 0 to 3.3V, so the duty cycle D of the PWM signal should be: $D = Ur / 3.3 V = 2.6667 V / 3.3 V = 0.81 = 81 %$

That is, when the duty cycle of the PWM signal output from the control chip MCU is 81%, the output voltage is exactly 10V.

In an embodiment of the present application, as shown in FIG. 4 and FIG. 5, the drive circuit 10 also includes a protection module 106, and the protection module 106 is in electrical connection with the current regulation module 104 and the load 20 respectively.

Particularly, the protection module 106 may be switched to a protection state under a preset condition. The preset condition may be that other high voltage is mistakenly connected to both ends of the load 20, and the high voltage across the load 20 can promote the protection module 106 to switch to the protection state. The preset condition may also be an output overload, at which point the current flowing through the protection module 106 rapidly increases, prompting the protection module 106 to switch to the protective state. Thus, by providing the protection module 106, it is ensured that the drive circuit 10 will not be damaged by high voltage, thereby the reliability and stability of power supply to the load 20 are enhanced.

In an embodiment of the present application, as shown in FIG. 5, the protection module 106 includes a first TVS diode TVS1 and a first thermistor PTC1. A first end of the first TVS diode TVS1 is in electrical connection with a first end of the first thermistor PTC1 and the current regulation module 104 respectively, a second end of the first TVS diode TVS1 is grounded, and a second end of the first thermistor PTC1 is configured to be electrically connected to the load 20.

Particularly, when the output overload occurs and the current flowing through the first thermistor PTC1 exceeds its trigger current, the protection is triggered. When other high voltage is mistakenly connected to both ends of the load 20, the high voltage across the load 20 can break through and conduct the first TVS diode TVS1, so that the current flowing through the first thermistor PTC1 increases rapidly and exceeds the trigger current of the first thermistor PTC1, and the first thermistor PTC1 presents a high resistance state, thereby the protection of the drive circuit 10 is achieved. Exemplarily, the first TVS diode TVS1 may select SMBJ12CA (which has a clamping voltage of 14 V and a breakdown voltage (preset voltage) of 13.3 V), and the first thermistor may be selected from 60R050 (which has a rated current of 50 mA and a trigger current (preset current) of 100 mA).

It should be noted that the embodiments provided in the present application only illustrate one circuit structure as the protection module 106, which does not mean that only this circuit structure can achieve the function of the protection module 106. Other circuit structures capable of achieving this function may also be substituted, and are not limited to this.

It should be noted that the drive circuit 10 provided in the present application is suitable for both active and passive loads, ensuring signal stability.

The present application also discloses an electronic device which includes the aforementioned drive circuit 10. By adopting the aforementioned drive circuit 10, the electronic device can effectively overcome the problems of weak load-driving capacity and low output accuracy in traditional drive circuits. It can meet the strict requirements for analog signal processing in scenarios such as industrial automation control and high-precision measuring instruments, thereby the comprehensive performance and market competitiveness of the electronic device is enhanced.

It should be noted that the electronic device may be a signal driver (such as a 0-10V signal driver), a signal generator and the like, and the present application pertains to the field of analog signal control technology, and is particularly applicable to scenarios such as smart homes and industrial control systems that require high-precision 0-10V signal output.

Since the processing and functions realized by the electronic device in this embodiment are basically corresponding to the principles and examples of the drive circuit in the foregoing embodiments, for details not elaborated in the description of this embodiment, please refer to the relevant explanations in the aforementioned embodiments, which will not be reiterated here.

The embodiments described above are only intended to illustrate the technical schemes of the present application and do not constitute any limitations thereof. Although the present application is described in detail with reference to the foregoing embodiments, it should be understood by persons skilled in the art that the technical schemes recorded in the foregoing embodiments may still be modified, or some technical features may be substituted by equivalents. These modifications or substitutions do not make the essence of the corresponding technical schemes deviate from the spirit and scope of the technical schemes of the embodiments of the present application, and should all be included within the protection scope of the present application.

## Claims

1. A drive circuit (10), comprising:
a control module (101),
an operational amplifier module (103);
an integral filter module (102), in electrical connection with the control module (101) and the operational amplifier module (103) respectively; and
a current regulation module (104), in electrical connection with the operational amplifier module (103), and configured to be electrically connected to a load (20);
wherein the control module (101) is configured to output a first voltage signal to the integral filter module (102), the integral filter module (102) is configured to output a second voltage signal to the operational amplifier module (103) according to the first voltage signal, the operational amplifier module (103) is configured to output a first operational amplifier signal to the current regulation module (104) according to the second voltage signal and a node voltage, the node voltage is a voltage at a common node of the current regulation module (104) and the load (20), and the current regulation module (104) is configured to increase a current delivered to the load (20) in response to the first operational amplifier signal.

2. The drive circuit (10) according to claim 1, wherein the integral filter module (102) comprises a first resistor (R1) and a first capacitor (C1), a first end of the first resistor (R1) is in electrical connection with the control module (101), a second end of the first resistor (R1) is in electrical connection with a first end of the first capacitor (C1) and the operational amplifier module (103) respectively, and a second end of the first capacitor (C1) is grounded.

3. The drive circuit (10) according to claim 1, wherein the operational amplifier module (103) comprises a second resistor (R2), a third resistor (R3) and a first operational amplifier (U1), a first input end of the first operational amplifier (U1) is in electrical connection with the integral filter module (102), a second input end of the first operational amplifier (U1) is in electrical connection with a first end of the second resistor (R2) and a first end of the third resistor (R3) respectively, an output end of the first operational amplifier (U1) is in electrical connection with the current regulation module (104), a second end of the second resistor (R2) is grounded, and a second end of the third resistor (R3) is configured to be electrically connected to the load (20).

4. The drive circuit (10) according to claim 1, wherein the current regulation module (104) comprises a fourth resistor (R4), a fifth resistor (R5), a sixth resistor (R6), a first transistor (Q1) and a second transistor (Q2), a first end of the fourth resistor (R4) is configured to be electrically connected to a first power supply, a second end of the fourth resistor (R4) is in electrical connection with a collector of the first transistor (Q1), a first end of the fifth resistor (R5) is in electrical connection with a first end of the sixth resistor (R6) and the operational amplifier module (103) respectively, a second end of the fifth resistor (R5) is in electrical connection with a base of the first transistor (Q1), a base of the second transistor (Q2) is in electrical connection with a second end of the sixth resistor (R6), a collector of the second transistor (Q2) is grounded, and an emitter of the second transistor (Q2) is in electrical connection with an emitter of the first transistor (Q1) and the load (20) respectively.

5. The drive circuit (10) according to claim 1, wherein the control module (101) comprises a control chip (MCU), and the control chip (MCU) is in electrical connection with the integral filter module (102).

6. The drive circuit (10) according to any one of claims 1 to 5, wherein the drive circuit (10) further comprises a feedback module (105), the feedback module (105) is in electrical connection with the current regulation module (104) and the control module (101) respectively, the feedback module (105) is configured to output a feedback voltage signal to the control module (101) according to the node voltage, and the control module (101) is further configured to regulate the first voltage signal according to the feedback voltage signal.

7. The drive circuit (10) according to claim 6, wherein the feedback module (105) comprises a seventh resistor (R7) and an eighth resistor (R8), a first end of the seventh resistor (R7) is in electrical connection with a first end of the eighth resistor (R8) and the control module (101) respectively, a second end of the seventh resistor (R7) is grounded, and a second end of the eighth resistor (R8)s configured to be electrically connected to the load (20).

8. The drive circuit (10) according to any one of claims 1 to 5, wherein the drive circuit (10) further comprises a protection module (106), the protection module (106) is in electrical connection with the current regulation module (104) and the load (20) respectively, and the protection module (106) is configured to switch to a protection state under a preset condition.

9. The drive circuit (10) according to claim 8, wherein the protection module (106) comprises a first transient voltage suppressor (TVS) diode (TVS1) and a first thermistor (PTC1), a first end of the first TVS diode (TVS1) is in electrical connection with a first end of the first thermistor (PTC1) and the current regulation module (104) respectively, a second end of the first TVS diode (TVS1) is grounded, and a second end of the first thermistor (PTC1) is configured to be electrically connected to the load (20).

10. An electronic device, comprising the drive circuit (10) according to any one of claims 1 to 9.
